# EUROPEAN PATENT SPECIFICATION

(11) **EP 0 578 507 B1**
(45) Date of publication and mention of the grant of the patent: **28.09.2005**
(21) Application number: 93305418.1
(22) Date of filing: 09.07.1993
(51) Int. Cl.: G03F 7/42, C11D 3/30, C11D 3/26

(54) **Cleaning solutions including nucleophilic amine compound having reduction and oxidation potentials**
Reinigungsmittelzusammensetzung, das einem Redox Aminverbindung enthält
Composition de nettoyage à base d'un composé aminé redox

(30) Priority: 09.07.1992 US 911102; 21.06.1993 US 78657
(43) Date of publication of application: 12.01.1994
(73) Proprietor: EKC TECHNOLOGY, INC., California 94545 (US)
(72) Inventor: Lee,Wai Mun, Fremont,California 94539 (US); Pittman,Charles Uria Jr., Starkville,Mississippi 39759 (US); Small,Robert James, Stasuma Alabama 36572 (US)
(74) Representative: Gallafent, Richard John

(56) References cited:
- EP-A- 0 009 677
- EP-A- 0 219 789
- EP-A- 0 299 166
- EP-A- 0 300 463
- EP-A- 0 485 161
- US-A- 4 617 251

## Description

This invention is directed to resist and etching residue removing compositions comprising at least one nucleophilic amine compound which possesses reduction and oxidation potentials, at least one organic solvent which is miscible with the nucleophilic amine and water. The compositions are useful in removing resists and etching residue from micro-circuitry during fabrication processes.

During the fabrication of microcircuits, the precise positioning of a number of appropriately doped regions on a slice of semiconductor is required followed by the positioning of one or more interconnection patterns on the semiconductor. Positive-type resists have been extensively used as masking materials to delineate patterns on to a substrate so that the patterns can be subsequently etched or otherwise defined into the substrate. The final steps in preparing the substrate then involve removing the unexposed resist material and any etching residue from the substrate. Increasingly, however, plasma etching, reactive ion etching or ion milling is used to define the pattern in a substrate which renders the resist mask substantially impossible to remove by stripping agents heretofore commonly used for such or similar purposes containing one or more of the following solvents: halogenated hydrocarbons such as, for example, methylene chloride or tetrachloroethylene; amines and their derivatives such as, for example, dimethylformamide, dimethylacetamide, pyrrolidone, diethanolamine, and triethanolamine; glycol ethers, such as, for example, ethylene glycol monoethyl ether, 2-butoxyethanol, and 2-(butoxy-ethoxy)ethanol; and an alkylsulfone, such as, for example, dimethylsulfone.

Additionally, during such etching processing, an organometallic by-product compound can be formed on the sidewall of the substrate material. The above-mentioned solvents are also ineffective in removing such organometallic polymers. A recently developed technique effective for photoresist removal is plasma oxidation, also known as plasma ashing. However, while this process is effective for removing a photoresist, it is not effective for removing the organometallic polymer formed on the sidewall of the substrate during the etching process.

Further, polyimides are increasingly used in microelectronics as fabrication aids, passivants, and interlevel insulators. The use of a polyimide as a fabrication aid includes application of the polyimide as a photoresist, planarization layer in a multi-level photoresist scheme and as an ion implant mask. In these applications, the polymer is applied to a wafer or substrate, subsequently cured or patterned by a suitable method and removed after use. Many conventional strippers are not sufficiently effective in removing the polyimide layer once the polyimide has been subjected to a severe curing operation. The removal of such polyimides is normally accomplished by boiling the substrate in hydrazine or in oxygen plasma.

Accordingly, a composition suitable for stripping a resist so as to remove the resist rapidly and completely would provide substantial advantages over conventional strippers. Further, a composition capable of removing both the resist and organometallic by-products would provide even a greater advantage. As apparent, if an etching residue is not completely removed from the substrate, the residue can interfere with subsequent processes involving the substrate.

In addition to removing completely the resist material, particularly with the introduction of submicron process techniques to form wafers, there is a demand for cleaning technology for removing etching residue remaining following resist removal. The requirement for a cleaning solution to remove all types of residue generated as a result of plasma etching of various types of metals, such as aluminum, aluminum/silicon/copper, titanium, titanium nitride, titanium/tungsten, tungsten, silicon oxide, polysilicon crystal, etc., presents a need for more effective cleaning chemistry in the processing area.

More specifically, during the fabrication of microcircuits, the substrate surface can be aluminum, titanium, silicon oxide or polysilicon and patterns are delineated thereon by chemical etching. Increasingly, plasma etching, reactive ion etching or ion milling are used, and such etching processes produce undesirable by-products from the interaction of the plasma gases, reacted species and the photoresist. The composition of such by-products is generally made up of the etched substrates, underlying substrate, photoresist and etching gases. The formation of such by-products is influenced by the type of etching equipment, process conditions and substrates utilized. These by-products are generally referred to as "sidewall polymer," "veil," "picket fences," "rabbit ears" or "goat horns," and cannot be removed completely by either oxygen plasma or conventional solvents, such as N-methyl-2-pyrrolidone, diethyleneglycolmonobutyl-ether, dimethylacetamide or the like, which are conventionally used to remove resists. It is critical that all of the etching residue and the like be removed to provide a wafer having sufficient integrity for subsequent use of the wafer in microcircuitry.

Examples of alkaline/solvent mixtures useful as photoresist strippers, but not necessarily cleaners, known for use in stripping applications include dimethylacetamide or dimethylformamide and alkanolamines as described in U.S. Patent Nos. 4,770,713 and 4,403,029; 2-pyrrolidone, dialkyl-sulfone and alkanolamines as described in U.S. Patent Nos. 4,428,871, 4,401,747, and 4,395,479; and 2-pyrrolidone and tetramethylammonium hydroxide as described in U.S. Patent No. 4,744,834. Such stripping compositions, however, have only proven successful in cleaning "sidewall polymer" from the contact openings and metal line etching in simple microcircuit manufacturing involving a single layer of metal when the metal structure involves mainly Al-Si or Al-Si-Cu and the "sidewall polymer" residue contains only an organometallic compound with aluminum. The cleaning mechanism involving such materials has been studied by EKC Technology, Inc. and Intel Corp., as presented at the K.T.I. Conference in 1989 in the presentation entitled "Metal Corrosion in Wet Resist Stripping Process," by P. L. Pai, C. H. Ting, W. M. Lee and R. Kuroda. Due to the corrosive nature of such strippers as above described, the "sidewall polymer" is removed either by attacking the organoaluminum compound or the metal surface itself and causing the "sidewall polymer" residue to be lifted off. Further, in addition to the use of the stripping composition, mechanical scrubbing, such as ultrasonic vibration, is required to achieve complete removal of the "sidewall polymer."

The most current submicron processing techniques utilized in the industry involving multi-levels of metal and multi-level of interconnecting processes usually incorporate metal materials including TiN, TiW, Ti, TiSi, W, WSi and the like. The use of such materials results in the generation of new organometallic material by-products during plasma etching, whether formed intentionally or unintentionally, which renders the cleaning incomplete when utilizing existing commercially available stripping and cleaning products.

Such findings were described at the SPIE Symposium on Micro-lithography in 1991 in a presentation entitled "Plasma Etching and Reactive Ion Etching" by John W Coburn. In particular, it has been found that the residue remaining on the substrate surface after removal of a resist by plasma ashing has changed from the organometallic to the corresponding oxide, such as TiO₂, which is chemically inert to mild alkaline strippers. The effect of such poor cleaning results in low device yield, low device reliability and low device performance.

Therefore, conventional stripping compositions are ineffective in removing sidewall organometallic and other metal oxide residue which is present following use of the current technology to remove resists. Even plasma ashing, which has been found effective for removing photoresists, is not effective for removing the sidewall organometallic polymer and some other of the metal oxide residues formed during etching processes.

Published European Patent Application No 485,161 A1 discloses hydroxylamine in combination with an alkanolamine which is miscible with the hydroxylamine as being useful to remove a resist from a substrate. It has now been found that compounds other than hydroxylamine and an alkanolamine are useful for removing resists, but in particular are also useful in removing etching residues from substrates.

The problem underlying the invention is accordingly to provide improved resist and etching residue removing stable compositions which will completely remove a resist and clean a microcircuitry substrate, and do so without adversely damaging the substrate surface or hindering subsequent operation or process steps involving the substrate.

The present invention is based on the discovery that certain nucleophilic amine compounds having oxidation and reduction potentials satisfactorily remove resists and etching residue from a substrate when combined with an organic solvent which is miscible with the nucleophilic amine compound and water. While the nucleophilic amine compound must have the potential for reduction and oxidation, it is not required that reduction and oxidation actually occur in the use of the composition. The nucleophilic amine compound must only possess oxidation and reduction qualities in a cleaning or stripping environment. Examples of nucleophilic amine compounds useful in the present invention include hydroxylamines, hydrazines, certain specified amines, and their derivatives as further described below.

The present invention provides a resist and etching residue removing composition for removing residue remaining following etching comprising (a) from about 5-50% by weight of one or more nucleophilic amine compounds having oxidation and reduction potentials selected from the group consisting of a compound having a formula: 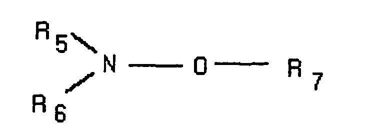 wherein R_{5,} R₆ and R₇ are independently hydrogen, a hydroxyl group, a substituted C₁-C₆ straight, branched or cycloalkyl, alkenyl, or alkynyl group, a substituted acyl group, straight or branched alkoxy group, amidyl group, carboxyl group, alkoxyalkyl group, alkylamino group, alkylsulfonyl group, or sulfonic acid group, or salts thereof and derivatives thereof; and hydrazines represented by a formula: 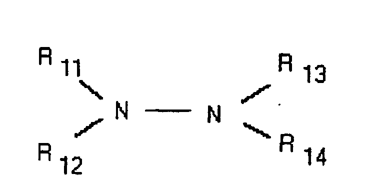 wherein R₁₁, R₁₂, R₁₃ and R₁₄ are independently hydrogen, a hydroxyl group, a substituted C₁-C₆ straight, branched or cycloalkyl, alkenyl, or alkynyl group, a substituted acyl group, straight or branched alkoxy group, amidyl group, carboxyl group, alkoxyalkyl group, alkylamino group, alkylsulfonyl group, or sulfonic acid group, or salts thereof; (b) from about 10-80% by weight of one or more organic solvents which are miscible with the nucleophilic amine compound; (c) water; and, optionally, (d) from about 2.5-30% by weight of one or more compounds selected from the group consisting of
a dihydroxybenzene compound having a formula: 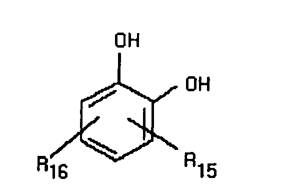 or isomer thereof wherein R₁₅ and R₁₆ can be either H, t-butyl, OH or COOH,
a compound having a formula: 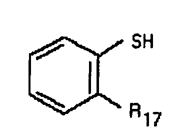 where R₁₇ is OH or COOH,
an ethylene diamine tetracarboxylic acid having a formula: 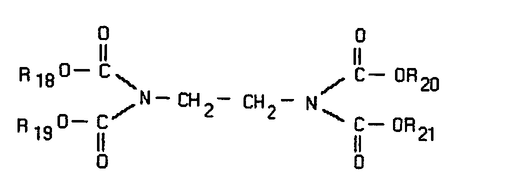 where R₁₈, R₁₉, R₂₀ and R₂₁ can be either H or NH₄ and an ammonium salt thereof,
and an alkyl ammonium hydroxide of formula:

R₁R₂R₃R₄NOH,

wherein R₁, R₂, R₃ and R₄ can be independently either H or a short chain alkyl group having from 1 to 5 carbon atoms, with the proviso that, when component (d) is not present, at least one of R₅, R₆ and R₇ is not hydrogen, and at least one of R₁₁, R₁₂, R₁₃ and R₁₄ is not hydrogen;
and wherein the nucleophilic amine compound and the organic solvent are present in sufficient amounts to remove resist and etching residue from a substrate.

The water used on the composition is preferably high purity deionised water.

It has been found that when component (d) is present, at least two additional surprising benefits are achieved, namely (1) the component (d) assists in cleaning by retaining etching residue in the cleaning solution and thereby avoiding resettling of the residue on to the substrate and (2) the component (d) serves as a stabilizing agent to provide long term effectiveness to the composition. More specifically, it enhances the cleaning capability of the composition by retaining of "freezing" the etching residue in the cleaning solution after the nucleophilic amine compound has picked up the residue from the substrate. This action minimises resettling of any residue on to the substrate. The presence of the component (d) further provides the composition with long term stability and activity and, therefore, a long shelf life. When component (d) is not present in the aqueous solution of a nucleophilic amine compound and organic solvent, the solution has only short term stability, i.e. generally an active life of about one week. Accordingly, when component (d) is not present, it is preferable to maintain the nucleophilic amine compound and organic solvent separately until just prior to use. After the components are combined and the solution used, the remaining solution can be disposed of or, once the activity has decreased, the solution can be reactivated by the addition of a component (d). Preferred compounds for component (d) are dihydroxybenzenes and their derivatives as further described below.

The cleaning composition is especially useful in removing etching residue such as organometallic and metal oxide residue, particularly ones formed in plasma etching processes, from substrates which contain metal elements other than aluminum such as titanium (Ti), tungsten (W), silicon (Si) and silicon oxide (SiO₂). While the compositions of the invention are capable of removing resists from substrates, the compositions of the invention have been shown to have a surprising capacity for cleanly removing etching residue, in particular organometallic and metal oxide etching residue, from a substrate surface following removal of a resist therefrom. The extent and type of residue remaining following etching is determined by the etching equipment utilised, process conditions and substrates utilised. Currently in the industry, etching residue is extremely difficult to completely remove without damaging the substrate.

The cleaning compositions of the present invention are particularly suitable for removing organometallic and metal oxide residues from a substrate, in particular, during the fabrication of a submicron (i.e. less than 0.8 microns) integrated circuit without adversely affecting or hindering subsequent manufacturing operation or process steps involving the substrate. Further, the cleaning compositions of the invention are effective in removing organometallic residue outgasing which has been deposited on parts of the etching equipment utilised in the processing. This equipment can be made of polycarbonate, ceramic or aluminium.

The method of removing a resist or etching residue from a substrate using the compositions of the present invention also is advantageous in that complex process steps and equipment are not required. The method of the invention involves contacting a substrate containing a resist or etching residue with the composition of the invention as described herein at a temperature and for a time sufficient to remove the particular resist or etching residue present.
Figure 1 shows etched wafer residue following the use of plasma ashing to remove a resist from a silicon oxide dielectric layer which had been earlier plasma etched.
Figure 2 shows the results of an analysis using ion mass spectrometry (LIMA) of the residue shown in Figure 1. Such analysis indicates that the residue contains metal oxide and trace amounts of organic material.
Figures 3A and 3B show the results of a comparison test utilising a cleaning composition of the present invention (Figure 3A) and a stripping composition as described in US Patent No 4,403,029 (Figure 3B) in relation to a silicon oxide dielectric layer containing etching residue thereon which is present following removal of a resist by plasma ashing. By comparing Figure 3A with Figure 3B, it can be seen that all the organometallic residue was removed using the composition of the present invention while residue remained following use of the stripping composition described in US Patent No 4,403,029.
Figures 4A and 4B show the results of a comparison test utilising a cleaning composition of the present invention (Figure 4A) and a stripping composition as described in US Patent No 4,770,713 (Figure 4B) in relation to a silicon dielectric layer which contained etching residue following removal of a resist therefrom by plasma ashing. As evident upon a comparison of Figure 4A with Figure 4B, the composition of the present invention removed all the organometallic residue while the other composition did not.
Figure 5A shows a microcircuit pattern of poly-silicon over silicon oxide containing etching residue which remained on the substrate following plasma etching. Figure 5B shows the same microcircuit pattern following cleaning with a composition of the present invention. As evident from a comparison of Figure 5A with Figure 5B, it can be seen that the residue has been removed.
Figure 6A shows residue which remained on a metal substrate after the removal of a photoresist from the substrate by plasma ashing. Figure 6B shows the same substrate following cleaning with a composition of the present invention.
Figures 7A-7D show the results of comparison tests using a cleaning composition of the present invention (Figures 7A and 7B) and an N-methyl-2-pyrrolidone solvent/alkanolamine base stripper (Figures 7C and 7D) in relation to openings on a silicon oxide dielectric layer. As shown in Figures 7A and 7B, all the organometallic residue was removed using the composition of the present invention while, as evident from Figures 7C and 7D, residue remained on the substrate treated with the stripper.
Figure 8A shows residue remaining on a wafer following etching and the removal of a photoresist therefrom. Figure 8B shows the same wafer following cleaning with a composition of the present invention. All the residue on the wafer was removed.
Figure 9 illustrates the results of Example 11 below wherein the stability of cleaning Compositions A, C and G were compared.

The preferred nucleophilic amine compounds having reduction and oxidation potentials are alkoxy substituted amines, hydroxylamine, alkyl or carboxyl substituted hydroxylamine, and alkyl or carboxyl substituted hydrazine. The most preferred compounds are hydroxylamine, N-methyl-hydroxylamine hydrochloride, N,N-diethylhydroxylamine and methylhydrazine.

Organic solvents suitable for use in the present invention are preferably water-soluble. Additionally, the organic solvent useful in the present invention preferably has a relatively high boiling point, such as for example 100°C or above, and a high flash point, such as for example 45°C or above.

Suitable organic solvents include alkanolamines and their derivatives. Additionally, non-amine solvents, such as dimethyl sulfoxide (DMSO) are suitable for use. Preferably an amine solvent is present alone or in combination with another solvent. Previously, it had been believed that an alkanolamine solvent had to be utilised. While an alkanolamine solvent is still a preferred solvent, it has now been found that other solvents are suitable for use when utilised with at least one nucleophilic amine compound having reduction and oxidation potentials.

Suitable alkanolamines are primary, secondary or tertiary amines and are preferably monoamines, diamines or triamines, and, most preferably, monoamines. The alkanol group of the amines preferably has from 1 to 5 carbon atoms.

Preferred alkanolamines suitable for use in the present invention can be represented by the chemical formula R₁R₂-N-CH₂CH₂-O-R₃ wherein R₁ and R₂ can be H, CH₃, CH₃CH₂ or CH₂CH₂OH and R₃ is CH₂CH₂OH.

Examples of suitable alkanolamines include monoethanolamine, diethanolamine, triethanolamine, tertiary-butyldiethanolamine isopropanolamine, 2-amino-1-propanol, 3-amino-1-propanol, isobutanolamine, 2-amino-2-ethoxy-propanol and 2-amino-2-ethoxy-ethanol, which is also known as diglycolamine.

Additional examples of organic solvents suitable for use in the composition of the present invention include N-methyl-2-pyrrolidone, N,N-dimethylpropanamide, N,N-diethylformamide, ethylene glycol, ethylene glycol alkyl ether, diethylene glycol alkyl ether, triethylene glycol alkyl ether, propylene glycol, propylene glycol alkyl ether, dipropylene glycol alkyl ether, tripropylene glycol alkyl ether, N-substituted pyrrolidone, ethylenediamine, and ethylenetriamine. Additional polar solvents as known in the art can also be used in the composition of the present invention.

The preferred compounds for component (d) are the dihydroxybenzene isomers, and the alkyl substituted dihydroxybenzenes. The most preferred compounds are 1,2-dihydroxybenzene and 1,2-dihydroxy-4-t-butylbenzene.

A presently most preferred cleaning composition of the invention comprises, based on the total weight of the composition, 35 parts hydroxylamine, 65 parts 2-amino-2-ethoxyethanol, and 5 parts 1,2-dihydroxybenzene, wherein the hydroxylamine is present as a 50% aqueous solution. Other preferred specific embodiments are set forth in the examples below. chelating agents can be utilized, such as thiophenol and its derivative according to the formula - 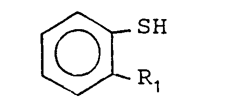 where R₁ = OH or COOH; or ethylene diamine tetracarboxylic acid, of the formula - 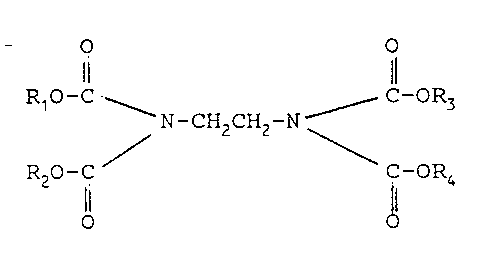 wherein R₁, R₂, R₃ and R₄ can be either H or NH₄, and its ammonium salt. Sodium, potassium or the like salts are not believed to be suitable for use based upon the understood mechanism of ionic contamination in a microcircuit as caused by cleaning. As evident from the above formula, the carboxylic acid can be mono-, di- or tri-substituted rather than tetra-substituted.

Additional suitable chelating agents include alkyl ammonium hydroxides which can be represented by the formula R₁R₂R₃R₄NOH wherein R₁, R₂, R₃, and R₄ are short chain alkyl groups, having from 1 to 5 carbon atoms, and wherein R₁, R₂, R₃, and R₄ can be the same or different. A preferred alkyl ammonium hydroxide is tetramethylammonium hydroxide.

A presently most preferred cleaning composition of the invention comprises, based on the total weight of the composition, 35 parts hydroxylamine, 65 parts 2-amino-2-ethoxyethanol, and 5 parts 1,2-dihydroxybenzene, wherein the hydroxylamine is present as a 50% aqueous solution. Other preferred specific embodiments are set forth in the examples below.

Examples of substrates from which the stripping and cleaning compositions of the present invention remove photoresists without attacking the substrates themselves include metal substrates such as aluminum, titanium/tungsten, aluminum/silicon, aluminum/silicon/copper; and substrates such as silicon oxide, silicon nitride, and gallium/arsenide; and plastic substrates such as polycarbonate.

The cleaning compositions of the present invention are also effective in removing etching residue from etching equipment utilized in etching substrates. Examples of commercially available etching equipment include Lam Research, Tegal, Electrotech, Applied Material, Tokyo Electron, Hitachi, and the like.

The method of removing a resist from a substrate or cleaning etching residue from a substrate using the compositions of the present invention involves contacting a substrate having a material to be removed with a composition of the present invention for a time and at a temperature sufficient to remove the residue. The substrate is immersed in the composition. The time and temperature of immersion are determined based on the particular material being removed from a substrate. Generally, the temperature is in the range of from about ambient or room temperature to 100°C and the contact time is from about 2 to 60 minutes. A preferred method involves immersing a substrate sample, such as a wafer in the solution of the invention for 30 minutes at a temperature of about 65°C followed by placement of the substrate sample in a solvent bath for 10 minutes at about 80°-85°C and, thereafter, rinsing the substrate sample in a water bath.

Examples illustrating the removal of etching residue from a substrate are set forth below. The following examples are provided to further illustrate the present invention and are not intended to limit the scope of the present invention.

In the examples, the substrate is treated in conventional known manners prior to the treatment of the substrate with the compositions of the present invention.

Examples of cleaning compositions according to the present invention utilized in Examples 1-11 below for removing etching residue from a substrate are set forth in Table I below.

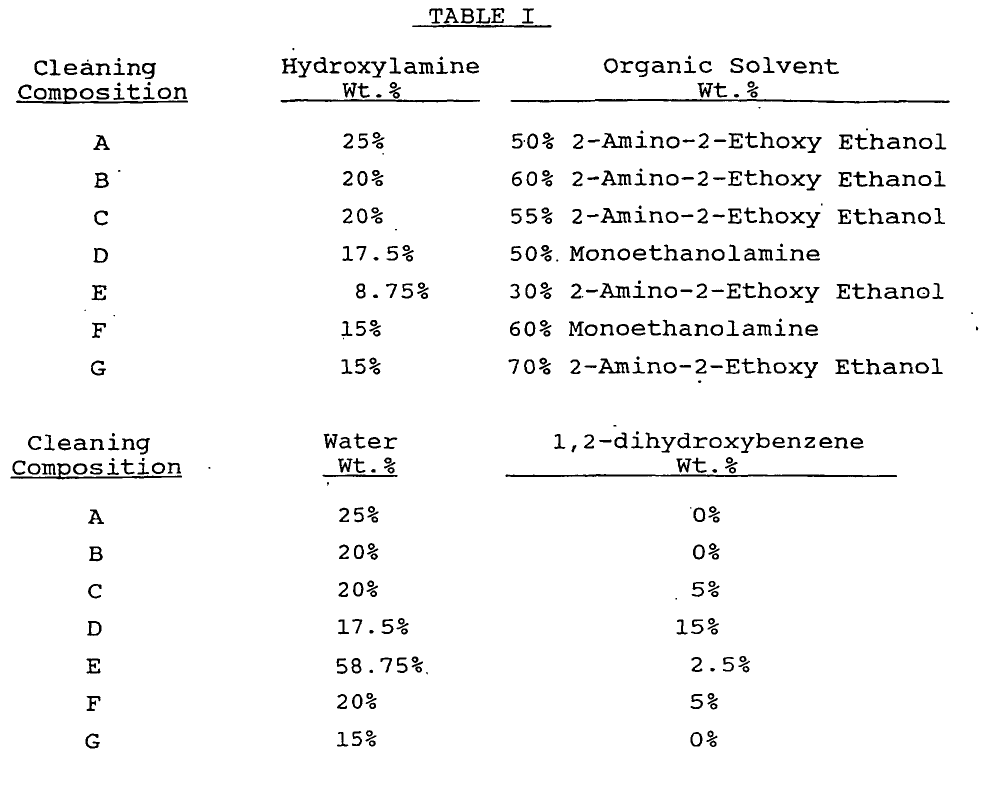

### EXAMPLE 1

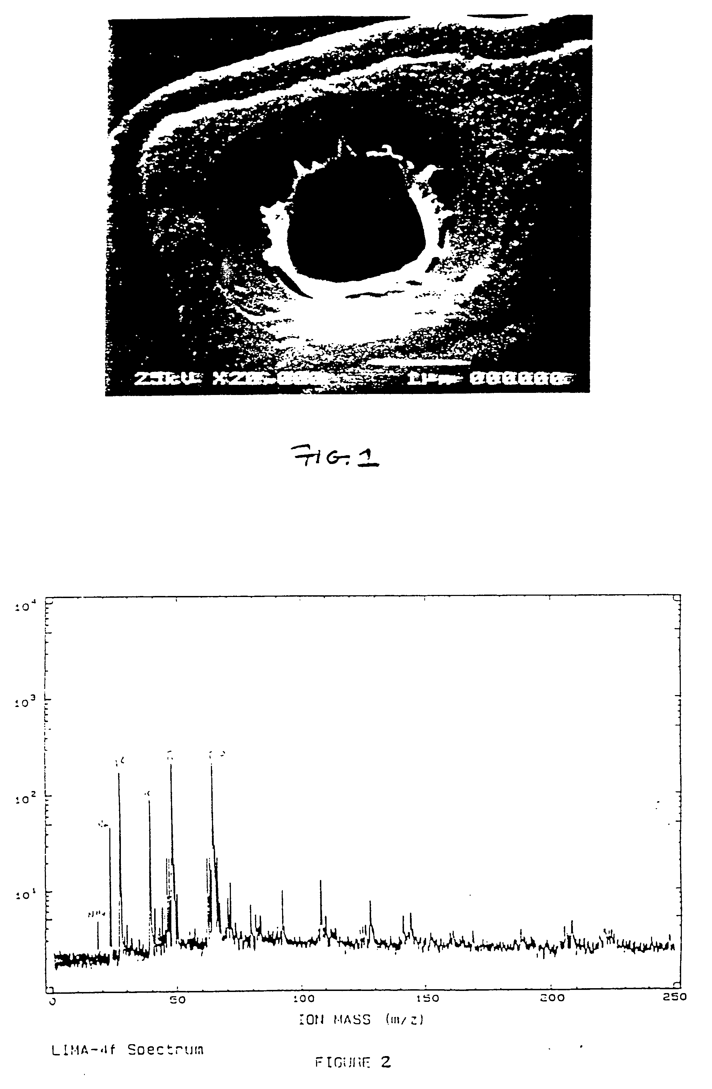

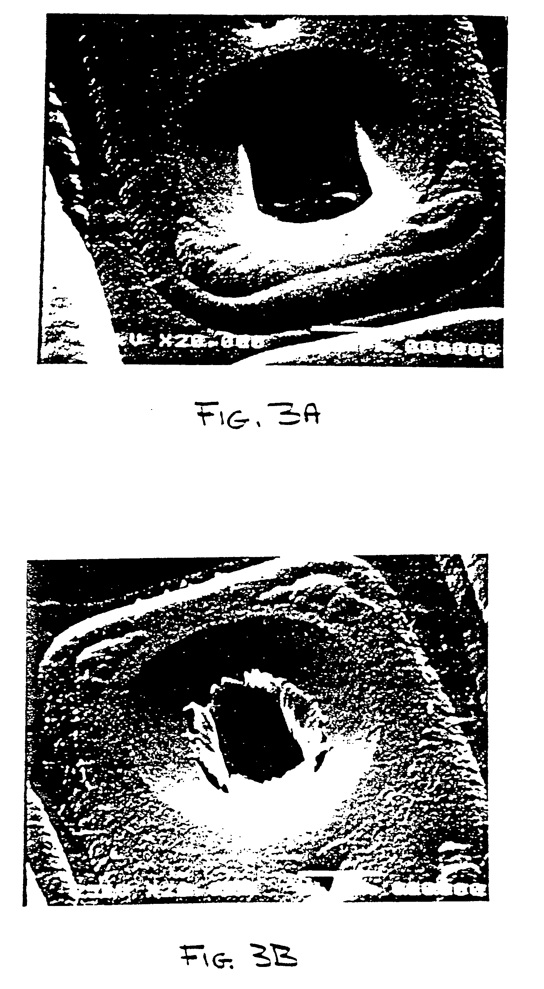

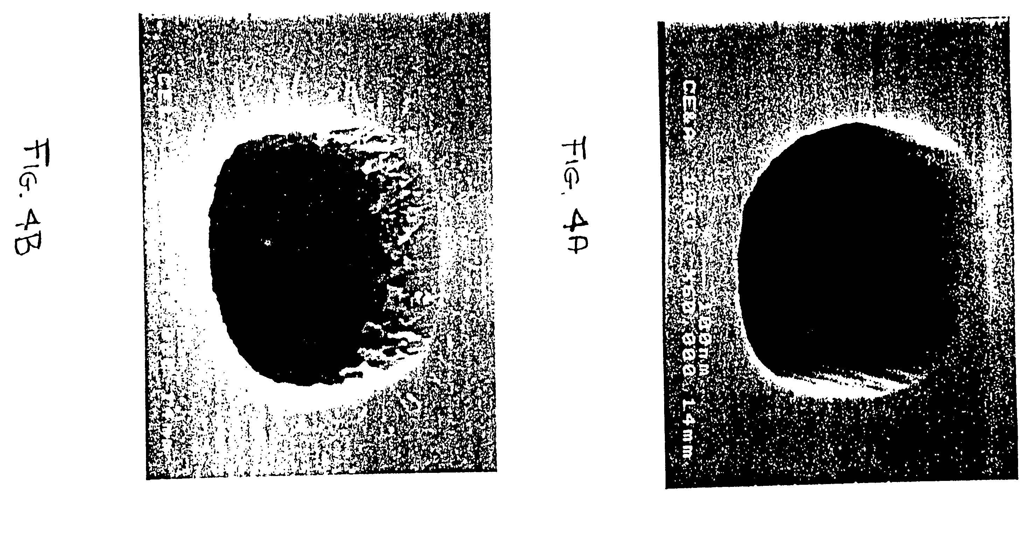

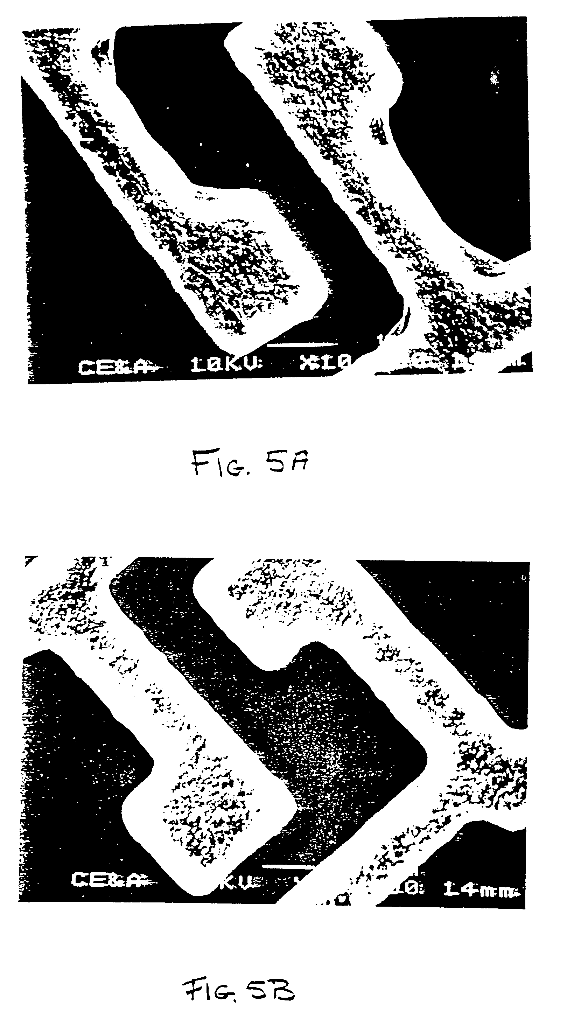

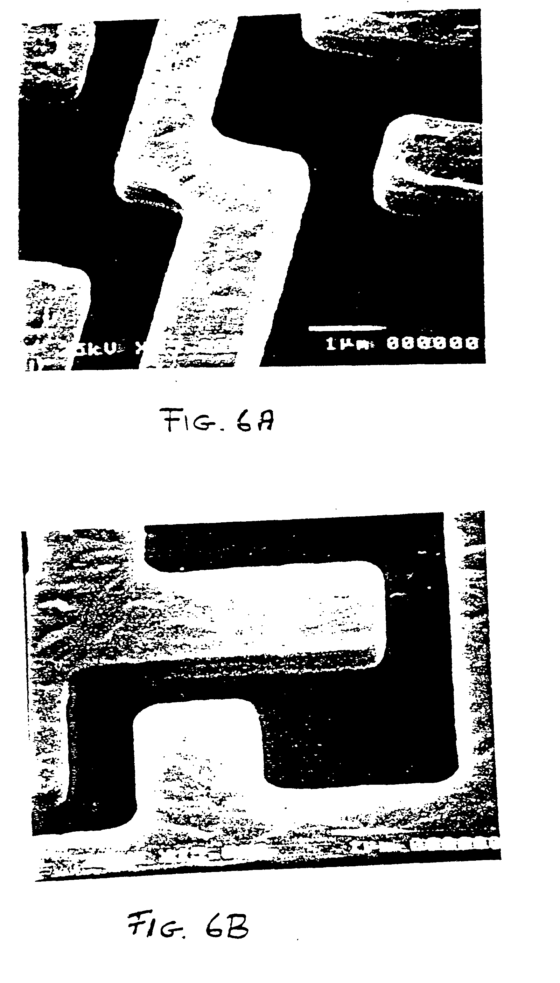

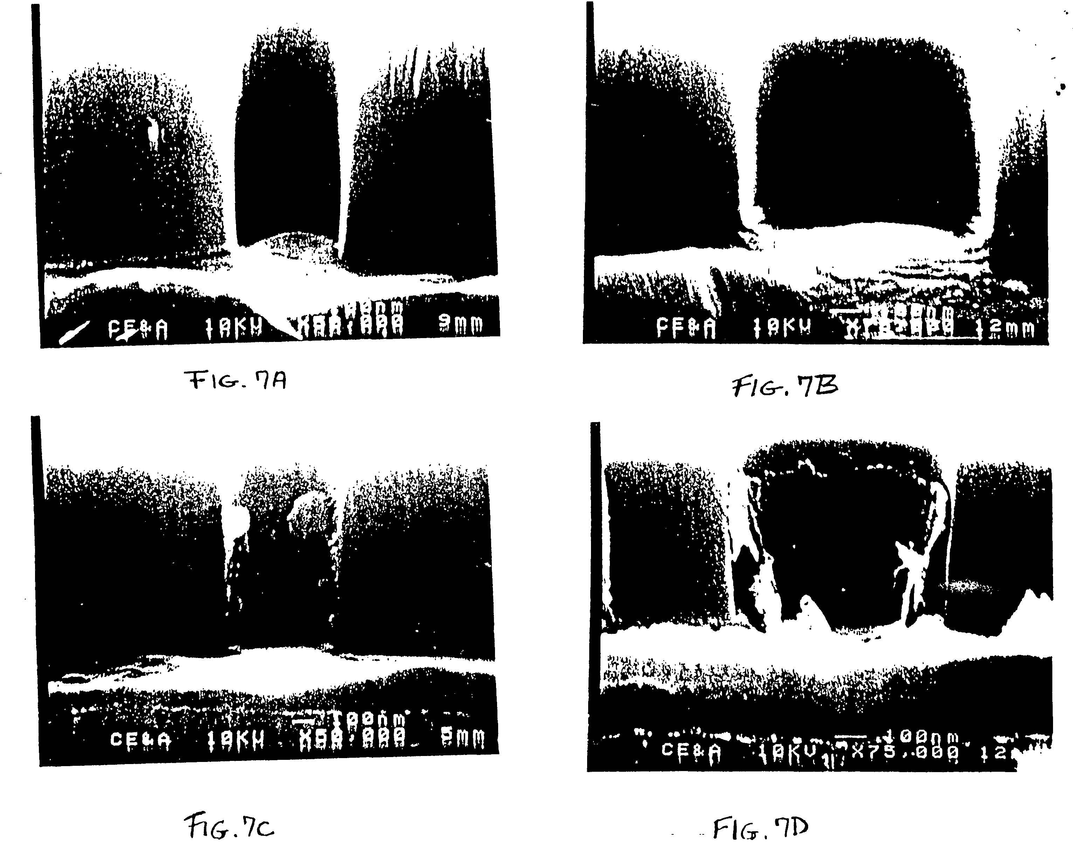

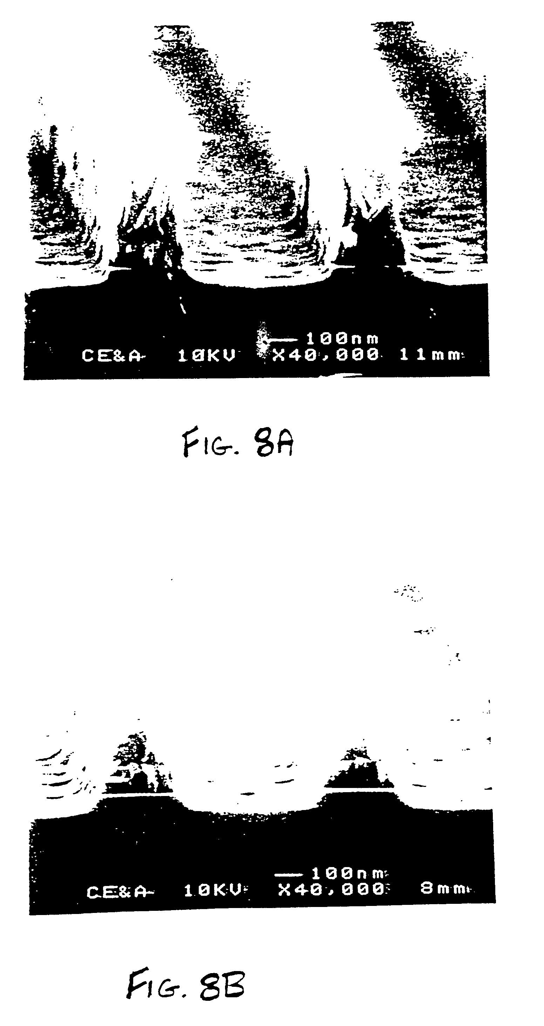

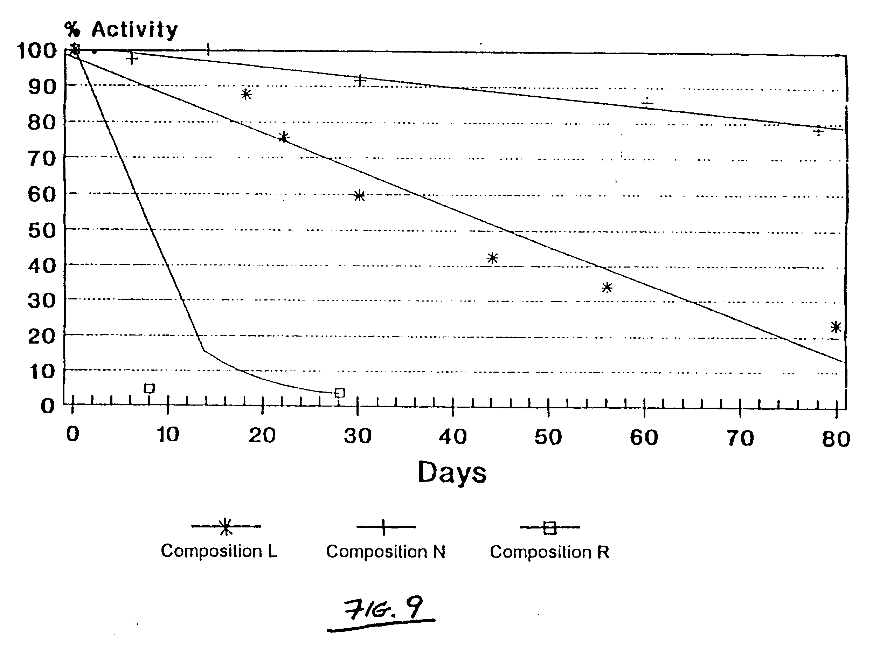

Example 1 illustrates the problem of residue remaining on a wafer substrate following plasma etching and ashing. FIGURE 1 shows etched wafer residue present on an etched substrate following plasma ashing. Specifically, silicon oxide used as a dielectric layer has a pattern etched for a multi-layer interconnect according to a standard plasma etching process. A photoresist which was used as a masking material has already been removed by oxygen plasma ashing. Analysis of the residue present on the etched wafer was analyzed by ion mass spectrometry (LIMA). The results of the analysis are as shown in FIGURE 2. The analysis confirms that the residue contains metal oxide and trace amounts of organic material.

### EXAMPLE 2

Example 2 illustrates the effect of the cleaning composition of the present invention on a wafer as determined by C/V testing. C/V shift measurement is a means utilized to determine the effect of a chemical used to clean a wafer. A high voltage shift is mainly caused by mobile ion contamination to the wafer. Such contamination will adversely affect subsequent process steps and may eventually cause failure of the microcircuits.

The test evaluation compares the C/V shift of different conventional photoresist stripping compositions to the cleaning composition of the present invention. All wafers used were known to be good silicon oxide substrates. All chemicals were heated on a hot plate to the manufacturers' suggested operating temperature using a pyrex beaker. Each of the beakers utilized was new and had not been previously used in any chemical processing. Individual beakers were used for each product. After immersing the silicon oxide wafer in the described composition, the wafers were rinsed and dried. Table II sets forth the operating conditions and the results of the C/V shift test. Table II is as follows:

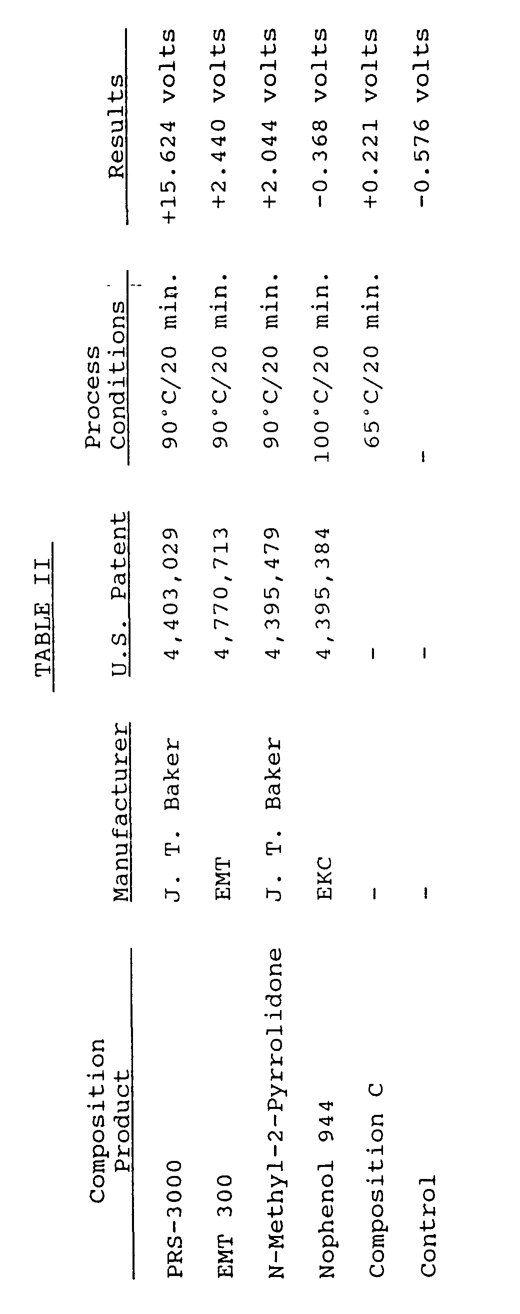

A negative reading means no change in C/V shift. The cleaning Composition C according to the present invention as described above was shown to provide a cleaner surface than any of the positive photoresist strippers tested.

### EXAMPLE 3

Example 3 illustrates the results of a comparison test between Composition F of the present invention as described above and the stripping composition described in U.S. Patent No. 4,403,029 and sold under the name PRS-2000 by J. T. Baker. The results of the comparison test are shown with respect to an opening having the size of 1.2 micron in FIGURES 3A and 3B. Each opening was present on a silicon oxide dielectric layer which was etched using a standard silicon oxide plasma etching process. The photoresist was removed from the layer following etching by oxygen plasma ashing. The substrate was then processed by immersing the substrate in Composition F as described above for 10 minutes at 65°C. A micrograph from a scanning microscope as shown in FIGURE 3A indicates that Composition F removed all the organometallic residue. As shown in FIGURE 3B, residue remained on the substrate when an etched wafer prepared under the same process conditions was processed by immersion in PRS-2000 for 10 minutes at 65°C.

### EXAMPLE 4

Example 4 illustrates the results of a comparison test between Composition C as described above and a stripping composition as described in U.S. Patent No. 4,770,713 and sold under the name ACT-150I. ACT-150I is a dimethylacetamide solvent based photoresist stripper.

The comparison test results are shown in FIGURES 4A AND 4B with respect to openings having a size of 1.0 micron. Each opening was present on a silicon oxide dielectric layer which was etched using a standard silicon oxide plasma etching process. The photoresist was removed by oxygen plasma ashing. The substrate was then processed by immersion in Composition C as described above for 30 minutes at 45°C. A micrograph from a scanning electron microscope as shown in FIGURE 4A shows that Composition C completely removed all the organometallic residue without damaging the silicon oxide substrate. FIGURE 4B shows a substrate prepared under the same process conditions after immersion in ACT-150I for 30 minutes at 45°C. As shown in FIGURE 4B, the stripping composition only partially removed the etching residue.

### EXAMPLE 5

Example 5 illustrates the cleaning of polysilicon etching residue. A microcircuit pattern of polysilicon over silicon oxide was etched in plasma etching equipment using HBr as an etching gas. The photoresist was removed by oxygen plasma ashing. The etching residue, which is mostly Si-C-Br, is shown in FIGURE 5A to remain on the polysilicon circuit line following the removal of the photoresist. When the wafer was further processed by immersion in Composition C of the present invention at 65°C for 20 minutes, all of the etching residue was removed from the substrate as shown in FIGURE 5B.

### Comparative EXAMPLE 6

Example 6 illustrates the cleaning of a metal etch residue from a substrate. A sandwich metal substrate of TiW/Al-Si-Cu/TiW was patterned and etched in a plasma metal etcher, i.e., Applied Material 8330 Metal Etcher. This metal etcher is a batch etching equipment and therefore is capable of treating more than one wafer at a time. Due to the manner of etching performed by such etching equipment, a lesser amount of "polymer" residue is built-up during etching. As shown in FIGURE 6A, residue remained on the metal line after the photoresist was removed by oxygen plasma ashing. The wafer was then processed by immersion in Composition B as described above at 65°C for 30 minutes. As shown in FIGURE 6B, Composition B served to remove all the organometallic residue from the surface.

### EXAMPLE 7

Example 7 illustrates the cleaning of a submicron circuit by means of via holes or openings, i.e., the holes on openings in the dielectric covering layer on a substrate which allow access to conductive material on the substrate, having a size of 0.6 microns on a silicon oxide dielectric layer which had been etched using a standard silicon oxide plasma etching processing. In particular, an oxide etcher as sold by Lam Research was utilized. In this process, the etching residue is mostly silicon containing polymer with a small ratio of metal in the composition. The underlying layer was a metal substrate of TiN/Al-Si-Cu. The photoresist masking material was removed by oxygen plasma ashing. The substrate was then processed by immersion in Composition A as described above for 30 minutes at 60°C. A cross-section micrograph from a scanning microscope as shown in FIGURE 7A indicates that Composition A removed all the organometallic residue. As shown in FIGURE 7B, however, residue remained inside the opening when an etched wafer processed in the same conditions was treated in N-methyl-2-pyrrolidone solvent/alkanolamine based stripper for 60 minutes at 90°C in an ultrasonic bath.

### EXAMPLE 8

Portions of silicon oxide etching equipment which are made of heavy gauge aluminum were removed from the etching equipment for cleaning. The conventional procedure utilized to remove the deposited outgas residue on the etching equipment is by sandblasting. Sandblasting, however, is a time consuming procedure. It has been found that the residue deposited on the aluminum portion of the etching equipment can be easily removed by immersion in a composition of the present invention. An aluminum portion of etching equipment was immersed in Composition E for 30 minutes at 40°C. Following rinsing and drying, it was observed that the residue was removed.

### EXAMPLE 9

The conventional process of cleaning a ceramic ring which forms a part of metal etching equipment involves either sandblasting or scrubbing by hand. Composition A was utilised to clean such ceramic ring by immersing the ceramic ring in an ultrasonic bath for 45 minutes at 35°C. It was found that the deposits on the ceramic ring were completely removed.

### EXAMPLE 10

Example 10 illustrates the cleaning of metal etch residue. An Al-Si-Cu/W/TiW metal pattern sitting on a plasma enhanced TEOS was utilised. The wafer had 50% over-etching. P-5000 as sold by Applied Material was used for the metal etching. The P-5000 is a single wafer etcher and due to the processing technique of the etching equipment, a higher build-up of polymer remains following the etching which is more difficult to remove than that described in Examples 6 and 7 above. A sandwich metal substrate of Al-Si-Cu/W/TiW was patterned and etched in the plasma metal etcher P-5000. The small amount of residue left on the corner of the metal line after the photoresist was removed by oxygen plasma ashing and was cleaned using Composition B at 65°C for 30 minutes. Such cleaned substrate is shown in Figure 8A. Composition B did not provide for complete removal of the residue. A similar etched wafer was then processed by immersion in Composition D as described above at 65°C for 30 minutes. As shown in Figure 8B, Composition D removed all the organometallic residue from the surface. Composition B does not contain a component (d) and Composition D contains a component (d). It is surmised that the activity of Composition B had begun to decrease due to its short term effectiveness based on the absence of component (d).

### EXAMPLE 11

Example 11 illustrates that cleaning solutions containing a component (d) have increased stability as compared to the cleaning solutions not containing such component. Compositions A, C and G, as described in Table I, were each placed in separate sealed Pyrex flasks and maintained at room temperature for a period of 80 days. A sample was taken from each flask at regular intervals and analysed to determine its activity. The activity of the cleaning compositions is measured by the reduction potential of the hydroxylamine. It can be seen from Figure 9 that Compositions G and A, which do not contain a component (d), lost their activity much faster than Composition C.

Examples 12-26 below are further illustrative of cleaning solutions prepared in accordance with the present invention. Examples 12-20 describe cleaning solutions having long term effectiveness due to the inclusion of catechol or dihydroxybenzene. Examples 21-26 are illustrative of cleaning solutions which do not contain a component (d) and therefore have short term effectiveness.

The procedure utilised with respect to Examples 12-26 involved mixing the composition components together followed by heating of the mixture to 65°C. Wafer samples were then immersed in the cleaning solution for 30 minutes with infrequent agitation. The wafer samples were then placed in an N-methyl-2-pyrrolidinone bath having a temperature of 80-85°C for 10 minutes. Thereafter, the wafer samples were rinsed in a water bath. In some of the Examples, the cleaning solution was subsequently diluted by the addition of 20 parts water and fresh wafer samples processed therein utilising the same procedure for comparative purposes. The dried wafers were evaluated by an SEM spectrometer.

As used in the Examples, "DGA" stands for diglycolamine which is also known as 2-amino-2-ethoxy ethanol, "DMSO" stands for dimethylsulfoxide and catechol is 1,2-dihydroxybenzene.

### EXAMPLE 12

A cleaning solution including 35 parts hydroxylamine (50% aqueous), 27 parts DGA, 5 parts catechol and 33 parts DMSO was prepared and utilized to clean a wafer. The wafer had a polysilicon structure and was completely cleaned with no damage to the structure by the cleaning solution. Wafers containing via holes also were cleaned of plasma etching residue.

The cleaning solution was thereafter diluted with 20 parts water and fresh wafer samples cleaned utilizing the solution. The additional water did not reduce the ability of the solution to clean polysilicon structures. The etching residue was satisfactorily removed from the wafer samples.

### EXAMPLE 13

A cleaning solution containing 34 parts hydroxylamine (50% aqueous), 5 parts catechol, 54 parts N-methyl-2-pyrrolidinone and 7 parts tetramethylammonium hydroxide (25% aqueous) was prepared and utilized to clean wafers having a metal structure. The wafers were cleaned of etching residue leaving no evidence of corrosion.

Thereafter, the cleaning solution was diluted with 20 parts water. Via holes in the wafers were cleaned with the diluted solution leaving no evidence of undercutting the substrate.

### EXAMPLE 14

A cleaning solution was prepared containing 35 parts hydroxylamine (50% aqueous), 59 parts DGA, 5 parts t-butyl-catechol and 1 part water. The solution was utilized to clean wafers having a polysilicon structure. The wafers were cleaned without pitting of the substrate.

Thereafter, 20 parts water was added to the cleaning solution. The diluted solution was utilized to clean fresh wafer samples. The dilution of the cleaning solution did not diminish the cleaning effect of the solution on polysilicon structures. Each of the solutions of Example 14 were satisfactorily effective on via holes with no evidence of undercutting of the wafer substrate.

### EXAMPLE 15

A cleaning solution was prepared containing 35 parts hydroxylamine (50% aqueous), 45 parts DGA, 5 parts catechol and 15 parts tetramethylammonium hydroxide (25% aqueous). The cleaning solution provided good cleaning of polysilicon structures with no pitting of the substrate.

### EXAMPLE 16

A cleaning solution was prepared containing 60 parts DGA, 5 parts catechol and 35 parts N,O-dimethylhydroxylamine (50% aqueous). The cleaning solution provided good cleaning of polysilicon structures and showed very satisfactory results in the cleaning of via holes.

Thereafter, the cleaning solution was diluted with 20 parts water and utilized to clean fresh wafers. Dilution of the cleaning solution did not diminish the cleaning ability of the solution.

### EXAMPLE 17

A cleaning solution was prepared containing 51 parts DGA, 5 parts catechol, 31 parts methoxylamine hydrochloride and 13 parts water. The cleaning solution cleaned metal structures leaving no corrosion on the structures.

Subsequently, when 20 parts water was added to the cleaning solution to dilute the solution, the diluted solution was found to clean polysilicon and via hole features with no apparent corrosion of the metal structure.

### EXAMPLE 18

A cleaning solution containing 60 parts DGA, 5 parts catechol and 35 parts N,N-diethylhydroxylamine was prepared. The cleaning solution cleaned metal structures with no apparent corrosion of the structures.

When the cleaning solution was diluted with 20 parts water, the solution adequately cleaned via holes and metal structures.

### EXAMPLE 19

A cleaning solution was prepared containing 61 parts DGA, 5 parts catechol and 34 parts acetohydroxamic acid. The cleaning solution provided acceptable polysilicon wafer cleaning.

Subsequent dilution of the cleaning solution with 20 parts water did not affect the ability of the solution to clean via hole structures in wafers.

### EXAMPLE 20

A cleaning solution was prepared containing 60 parts DGA, 5 parts catechol, and 35 parts methylhydrazine. The cleaning solution provided good results in cleaning wafer via holes.

Subsequent dilution of the cleaning solution with 20 parts water did not significantly diminish the solution's ability to clean via holes having plasma etch residues thereon.

### EXAMPLE 21

A cleaning solution containing 49 parts DGA, 4 parts catechol, 29 parts methylhydrazinocarboxylate, and 18 parts water was prepared. The cleaning solution was effective for cleaning polysilicon and via hole structures.

### EXAMPLE 22

A cleaning solution having short term effectiveness was prepared containing 35 parts hydroxylamine (50% aqueous), 60 parts DGA and 5 parts dimethylgloxime. The cleaning solution, when used just subsequent to its preparation, provided acceptable results for cleaning via holes.

When 18 parts water was subsequently added to the cleaning solution, via holes were still effectively cleaned of plasma etch residue by the diluted solution.

### EXAMPLE 23

A cleaning solution containing 60 parts DGA and 40 parts N,O-dimethylhydroxylamine (50% aqueous) was prepared. When utilized immediately following preparation of the solution, the cleaning solution cleaned polysilicon structures with no problem.

### EXAMPLE 24

A cleaning solution containing 53 parts DGA, 33 parts N-methylhydroxylamine hydrochloride and 14 parts water was prepared. The cleaning solution, when used immediately following preparation of the solution, cleaned polysilicon structures and via holes with no detrimental effect.

### EXAMPLE 25

A cleaning solution was prepared containing 60 parts DGA and 40 parts N,N-diethylhydroxylamine and 20 parts water. The cleaning solution cleaned polysilicon structures with no corrosion resulting when the solution was utilized immediately following its preparation.

### EXAMPLE 26

A cleaning solution was prepared containing 60 parts DGA, and 40 parts hydroxylamine (50% aqueous). The cleaning solution adequately cleaned polysilicon structures, via holes and metal structures. However, after approximately one week, the solution lost its effectiveness although the composition had not changed. Five parts catechol were then added to the solution and the solution reactivated. The reactivated solution was able to again clean wafer structures, including via holes.

Upon diluting the reactivated cleaning solution with 18 parts water, the cleaning ability of the solution was found to be undiminished.

From the various test results set forth in the Examples, it can be seen that the cleaning solutions of the present invention provide novel and surprising results. The composition allows for a simple method of use and is adaptable to various modifications while still providing the desired results. The composition of the invention therefore allows for broad application upon minor adjustments.

## Claims

1. A resist and etching residue removing composition for removing residue remaining following etching comprising (a) from about 5-50% by weight of one or more nucleophilic amine compounds having oxidation and reduction potentials selected from the group consisting of a compound having a formula: 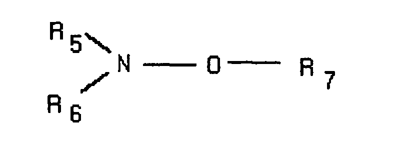 wherein R_{5,} R₆ and R₇ are independently hydrogen, a hydroxyl group, a substituted C₁-C₆ straight, branched or cycloalkyl, alkenyl, or alkynyl group, a substituted acyl group, straight or branched alkoxy group, amidyl group, carboxyl group, alkoxyalkyl group, alkylamino group, alkylsulfonyl group, or sulfonic acid group, or salts thereof and derivatives thereof; and hydrazines represented by a formula: 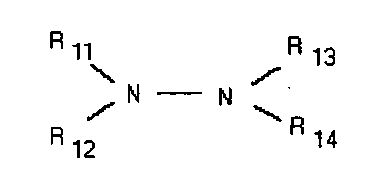 wherein R₁₁, R₁₂, R₁₃ and R₁₄ are independently hydrogen, a hydroxyl group, a substituted C₁-C₆ straight, branched or cycloalkyl, alkenyl, or alkynyl group, a substituted acyl group, straight or branched alkoxy group, amidyl group, carboxyl group, alkoxyalkyl group, alkylamino group, alkylsulfonyl group, or sulfonic acid group, or salts thereof; (b) from about 10-80% by weight of one or more organic solvents which are miscible with the nucleophilic amine compound; (c) water; and, optionally, (d) from about 2.5-30% by weight of one or more compounds selected from the group consisting of
a dihydroxybenzene compound having a formula: 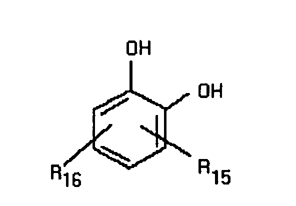 or isomer thereof wherein R₁₅ and R₁₆ can be either H, t-butyl, OH or COOH,
a compound having a formula: 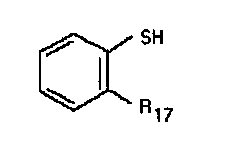 where R₁₇ is OH or COOH,
an ethylene diamine tetracarboxylic acid having a formula: 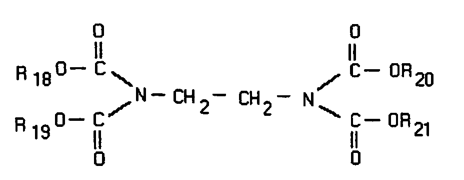 where R₁₈, R₁₉, R₂₀ and R₂₁ can be either H or NH₄ and an ammonium salt thereof,
and an alkyl ammonium hydroxide of formula:
R₁R₂R₃R₄NOH,
wherein R₁, R₂, R₃ and R₄ can be independently either H or a short chain alkyl group having from 1 to 5 carbon atoms, with the proviso that, when component (d) is not present, at least one of R₅, R₆ and R₇ is not hydrogen, and at least one of R₁₁, R₁₂, R₁₃ and R₁₄ is not hydrogen; and wherein the nucleophilic amine compound and the organic solvent are present in sufficient amounts to remove resist and etching residue from a substrate.

2. The composition according to Claim 1 wherein component (d) is present, and the nucleophilic amine compound of (a) is hydroxylamine, a hydroxylamine derivative, hydrazine, or a hydrazine derivative.

3. The composition according to Claim 2 wherein the nucleophilic amine compound of (a) is hydroxylamine, and component (d) comprises at least one compound of formula: 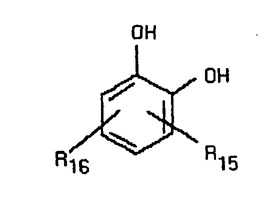 wherein R₁₅ and R₁₆ can be either H, t-butyl, OH or COOH and water, wherein the hydroxylamine, the at least one organic solvent of (b) and the at least one compound of (d) are present in sufficient amounts to remove etching residue or a resist from a substrate.

4. The composition according to Claim 1 wherein the nucleophilic amine compound of (a) is hydroxylamine, and the at least one compound of (d) is present in from about 5-30% by weight.

5. The composition according to Claim 1 wherein component (d) is present, and the nucleophilic amine compound of (a) is N,N-diethyl hydroxylamine.

6. The composition according to any of the preceding Claims wherein component (d) is present, and the organic solvent of (b) is an alkanolamine.

7. The composition according to Claim 6 wherein the alkanolamine has at least one alkanol group containing from 1 to 5 carbon atoms.

8. The composition according to Claim 6 wherein the alkanolamine is a monoamine or diamine.

9. The composition according to Claim 6 wherein the alkanolamine has the formula R₁R₂-N-CH₂CH₂-0-CH₂CH₂OH, wherein R₁ and R₂ can be H, CH₃, CH₃CH₂, or CH₂CH₂OH.

10. The composition according to Claim 6 wherein the alkanolamine is an amino alkoxy alkanol.

11. The composition according to Claim 6 wherein the alkanolamine is monoethanolamine, diglycolamine or monoisopropanolamine.

12. The composition according to Claim 1 wherein the nucleophilic amine compound of (a) is hydroxylamine and is present in an amount of about 17.5 percent by weight, the organic solvent of (b) is diglycolamine, and the diglycolamine is present in an amount of at least about 60 percent by weight, the compound of (d) is catechol, and the catechol is present in an amount of at least about 2 percent by weight, and the water is present in an amount of about 17.5 percent by weight.

13. The composition according to Claim 3 or 12 wherein the hydroxylamine and the water are present in a ratio of about 50:50.

14. A cleaning composition for removing resist and etching residue from substrates, containing hydroxylamine, at least one alkanolamine, water and a chelating agent.

15. The composition according to Claim 5 wherein the N,N-diethyl hydroxylamine is present in an amount of about 17.5 percent by weight, the organic solvent of (b) is diglycolamine and is present in an amount of at least about 60 percent by weight, and the water is present in an amount of about 17.5 percent by weight.

16. The use, for removing resist or etching residue remaining following etching from a substrate by contacting the substrate with a composition, of a composition comprising (a) from about 5-50% by weight of one or more nucleophilic amine compounds having oxidation and reduction potentials selected from the group consisting of a compound having a formula: 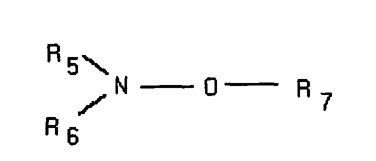 wherein R_{5,} R₆ and R₇ are independently hydrogen, a hydroxyl group, a substituted C₁-C₆ straight, branched or cycloalkyl, alkenyl, or alkynyl group, a substituted acyl group, straight or branched alkoxy group, amidyl group, carboxyl group, alkoxyalkyl group, alkylamino group, alkylsulfonyl group, or sulfonic acid group, or salts thereof and derivatives thereof; and hydrazines represented by a formula: 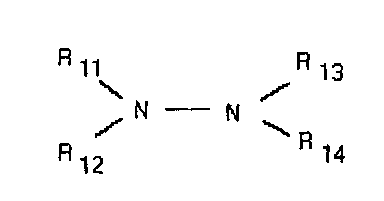 wherein R₁₁, R₁₂, R₁₃ and R₁₄ are independently hydrogen, a hydroxyl group, a substituted C₁-C₆ straight, branched or cycloalkyl, alkenyl, or alkynyl group, a substituted acyl group, straight or branched alkoxy group, amidyl group, carboxyl group, alkoxyalkyl group, alkylamino group, alkylsulfonyl group, or sulfonic acid group, or salts thereof; (b) from about 10-80% by weight of one or more organic solvents which are miscible with the nucleophilic amine compound; (c) water; and, optionally, (d) from about 2.5-30% by weight of one or more compounds selected from the group consisting of
a dihydroxybenzene compound having a formula: 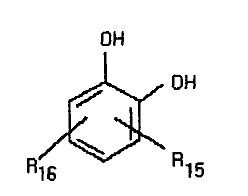 or isomer thereof wherein R₁₅ and R₁₆ can be either H, t-butyl, OH or COOH,
a compound having a formula: 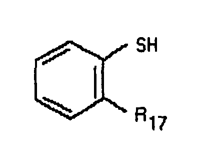 where R₁₇ is OH or COOH,
an ethylene diamine tetracarboxylic acid having a formula: 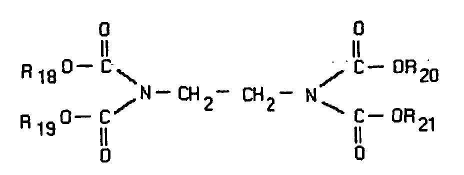 where R₁₈, R₁₉, R₂₀ and R₂₁ can be either H or NH₄ and an ammonium salt thereof,
and an alkyl ammonium hydroxide of formula:
R₁R₂R₃R₄NOH,
wherein R₁, R₂, R₃ and R₄ can be independently either H or a short chain alkyl group having from 1 to 5 carbon atoms, with the proviso that, when component (d) is not present, at least one of R₅, R₆ and R₇ is not hydrogen, and at least one of R₁₁, R₁₂, R₁₃ and R₁₄ is not hydrogen; wherein the contact is at a temperature and for a time sufficient to remove the etching residue or residual photoresist by-products from the substrate.

17. The use of a composition according to Claim 16, wherein component (d) is present, and the nucleophilic amine compound of (a) is a hydroxylamine, a hydroxylamine derivative, hydrazine, or a hydrazine derivative.

18. The use of the composition according to Claim 17, wherein the nucleophilic amine compound of (a) is hydroxylamine, and component (d) comprises at least one compound of formula: 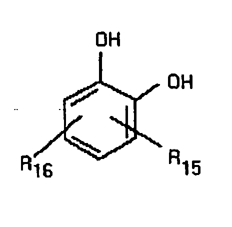 wherein R₁₅ and R₁₆ can be either H, t-butyl, OH or COOH and water, at a temperature and for a time sufficient to remove the etching residue or resist from the substrate.

19. The use of a composition according to Claim 16 wherein the nucleophilic amine compound of (a) is hydroxylamine, and the at least one compound of (d) is present in an amount of from about 5-30% by weight

20. The use of a composition according to Claim 16 wherein component (d) is present, and the nucleophilic amine compound of (a) is N,N-diethyl hydroxylamine.

21. The use of a composition according to any of Claims 16 to 20, wherein component (d) is present, and the organic solvent of (b) is an alkanolamine.

22. The use of a composition according to Claim 21, wherein the alkanolamine has at least one alkanol group containing from 1 to 5 carbon atoms.

23. The use of a composition according to Claim 21, wherein the alkanolamine is a monoamine or diamine.

24. The use of a composition according to Claim 21, wherein the alkanolamine has the formula
R₁R₂-N-CH₂CH₂-0-CH₂CH₂OH wherein R₁ and R₂ can be H, CH₃, CH₃CH₂ or CH₂CH₂OH.

25. The use of a composition according to Claim 21, wherein the alkanolamine is an amino alkoxy alkanol.

26. The use of a composition according to Claim 21, wherein the alkanolamine is monoethanolamine, diglycolamine or monoisopropanolamine

27. The use of a composition according to Claim 16, wherein the nucleophilic amine compound of (a) is hydroxylamine and is present in an amount of about 17.5 percent by weight, the organic solvent of (b) is diglycolamine, and the diglycolamine is present in an amount of at least about 60 percent by weight, the compound of (d) is catechol and the catechol is present in an amount of at least about 2 percent by weight, and the water is present in an amount of about 17.5 percent by weight.

28. The use of a composition according to Claim 18 or 27, wherein the hydroxylamine and the water are present in a ratio of about 50:50.

29. The use of a composition according to Claim 14 for removing resist and etching residue from substrates.

30. The use of a composition according to Claim 20 wherein the N,N-diethyl hydroxylamine is present in an amount of about 17.5 percent by weight, the organic solvent of (b) is diglycolamine and is present in an amount of at least about 60 percent by weight, and the water is present in an amount of about 17.5 percent by weight.

31. The use of a composition according to any of Claims 16 to 30 wherein the substrate is a semiconductor wafer.

32. The use of a composition according to any one of Claims 16 to 31, wherein the temperature is in the range of from about room temperature to 100°C and the time is in the range of from 2 to 60 minutes.

## Patentansprüche

1. Zusammensetzung zum Entfernen von Abdeckmaterialien und Ätzrückständen zur Rückstandsentfernung nach dam Ätzen, enthaltend (a) etwa 5 bis 50 Gew% eines oder mehrerer nucleophiler Amine, die ein Oxidations- und Reduktionspotential aufweisen und ausgewählt sind aus der Gruppe von Verbindungen der Formel 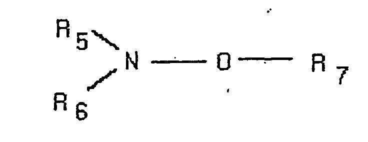 worin R₅, R₆ und R₇ unabhängig voneinander Wasserstoff, eine Hydroxylgruppe, einen substituierten, 1 bis 6 Kohlenstoffatome aufweisenden geradkettigen, verzweigten oder cyclischen Alkyl-, Alkenyl- oder Alkinylrest, einen substituierten Acylrest, einen geradkettigen oder verzweigten Alkoxyrest, einen Amidyl-, Carboxyl-, Alkoxyalkyl-, Alkylamino-, Alkylsulfonyl- oder Sulfonsäurerest bedeuten, oder Salzen und Derivaten hiervon, und aus Hydrazinen der Formel 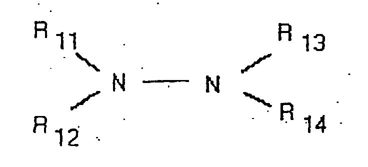 worin R₁₁, R₁₂, R₁₃ und R₁₄ unabhängig voneinander unabhängig voneinander Wasserstoff, eine Hydroxylgruppe, einen substituierten, 1 bis 6 Kohlenstoffatome aufweisenden, geradkettigen, verzweigten oder cyclischen Alkyl-, Alkenyl- oder Alkinylrest, einen substituierten Acylrest, einen geradkettigen oder verzweigten Alkoxyrest, einen Amidyl-, Carboxyl-, Alkoxyalkyl-, Alkylamino-, Alkylsulfonyl- oder Sulfonsäurerest bedeuten, oder Salzen hiervon, (b) etwa 10 bis 80 Gew% eines oder mehrerer organischer Lösungsmittel, die mit dem nucleophilen Amin mischbar sind, (c) Wasser und gegebenenfalls (d) etwa 2,5 bis 30 Gew% einer oder mehrerer Verbindungen, die ausgewählt sind aus der Gruppe, bestehend aus
einem Dihydroxybenzol der Formel 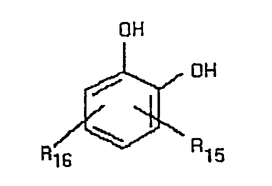 oder Isomeren hiervon, worin R₁₅ und R₁₆ entweder H, t-Butyl, OH oder COOH bedeuten,
einer Verbindung der Formel 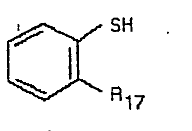 worin R₁₇ OH oder COOH bedeutet,
einer Ethylendiamintetracarbonsäure der Formel 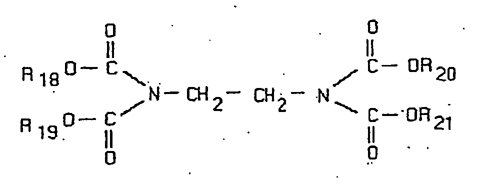 worin R₁₈, R₁₉, R₂₀ und R₂₁ entweder H oder NH₄ bedeuten, und einem Ammoniumsalz hiervon sowie
einem Alkylammoniumhydroxid der Formel
R₁R₂R₃R₄NOH
worin R₁, R₂, R₃ und R₄ jeweils unabhängig voneinander entweder H oder einen kurzkettigen Alkylrest mit 1 bis 5 Kohlenstoffatomen bedeuten, mit der Maßgabe, daß, wenn die Komponente (d) nicht vorliegt, mindestens einer der Reste R₅, R₆ und R₇ nicht Wasserstoff darstellt, und mindestens einer der Reste R₁₁, R₁₂, R₁₃ und R₁₄ nicht Wasserstoff bedeutet, wobei das nucleophile Amin und das organische Lösungsmittel in ausreichenden Mengen vorliegen, um das Abdeckmaterial und den Ätzrückstand von einem Substrat zu entfernen.

2. Zusammensetzung nach Anspruch 1, worin die Komponente (d) vorliegt und das nucleophile Amin gemäß (a) Hydroxylamin, ein Hydroxylaminderivat, Hydrazin, oder ein Hydrazinderivat ist.

3. Zusammensetzung nach Anspruch 2, worin das nucleophile Amin gemäß (a) Hydroxylamin ist und die Komponente (d) mindestens eine Verbindung der Formel 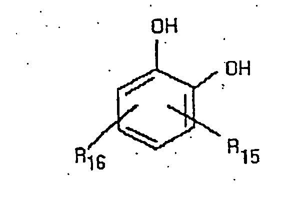 worin R₁₅ und R₁₆ entweder H, t-Butyl, OH oder COOH bedeuten, sowie Wasser enthält, wobei das Hydroxylamin, das mindestens eine organische Lösungsmittel gemäß (b) und die mindestens eine Verbindung gemäß (d) in ausreichenden Mengen vorliegen, um einen Ätzrückstand oder ein Abdeckmaterial von einem Substrat zu entfernen.

4. Zusammensetzung nach Anspruch 1, worin das nucleophile Amin gemäß (a) Hydroxylamin ist und die mindestens eine Verbindung gemäß (d) in einer Menge von etwa 5 bis 30 Gew% vorliegt.

5. Zusammensetzung nach Anspruch 1, worin die Komponente (d) vorliegt und das nucleophile Amin gemäß (a) N,N-Diethylhydroxylamin ist.

6. Zusammensetzung nach einem der vorstehenden Ansprüche, worin die Komponente (d) vorliegt und das organische Lösungsmittel gemäß (b) ein Alkanolamin ist.

7. Zusammensetzung nach Anspruch 6, worin das Alkanolamin mindestens einen Alkanolrest aufweist, der 1 bis 5 Kohlenstoffatome enthält.

8. Zusammensetzung nach Anspruch 6, worin das Alkanolamin ein Monoamin oder ein Diamin ist.

9. Zusammensetzung nach Anspruch 6, worin das Alkanolamin die Formel R₁R₂N-CH₂CH₂-0-CH₂CH₂OH aufweist, wobei R₁ und R₂ H, CH₃, CH₃CH₂ oder CH₂CH₂OH bedeuten können.

10. Zusammensetzung nach Anspruch 6, worin das Alkanolamin ein Aminoalkoxyalkanol ist.

11. Zusammensetzung nach Anspruch 6, worin das Alkanolamin Monöethanolamin, Diglykolamin oder Monoisopropanolamin ist.

12. Zusammensetzung nach Anspruch 1, worin das nucleophile Amin gemäß (a) Hydroxylamin ist und in einer Menge von etwa 17,5 Gew% vorliegt, das organische Lösungsmittel gemäß (b) Diglykolamin ist und in einer Menge von mindestens etwa 60 Gew% vorliegt, die Verbindung gemäß (d) Brenzkatechin oder Katechin ist und in einer Menge von mindestens 2 Gew% vorliegt und das Wasser in einer Menge von etwa 17,5 Gew% vorliegt.

13. Zusammensetzung nach Anspruch 3 oder 12, worin das Hydroxylamin und das Wasser in einem Verhältnis von etwa 50:50 vorliegen.

14. Reinigungszusammensetzung zum Entfernen eines Abdeckmaterials und eines Ätzrückstand von Substraten, enthaltend Hydroxylamin, mindestens ein Alkanolamin, Wasser und einen Chelatbildner.

15. Zusammensetzung nach Anspruch 5, worin das N,N-Diethylhydroxylamin in einer Menge von etwa 17,5 Gew% vorliegt, das organische Lösungsmittel gemäß (b) Diglykolamin ist und in einer Menge von mindestens etwa 60 Gew% vorliegt sowie das Wasser in einer Menge von etwa 17,5 Gew% vorliegt.

16. Verwendung einer Zusammensetzung, enthaltend (a) etwa 5 bis 50 Gew% eines oder mehrerer nucleophiler Amine, die ein Oxydations- und Reduktionspotential aufweisen und ausgewählt sind aus der Gruppe von Verbindungen der Formel 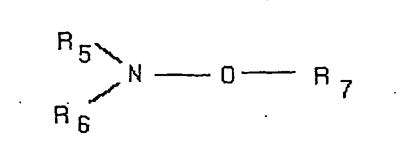 worin R₅, R₆ und R₇ unabhängig voneinander Wasserstoff, eine Hydroxylgruppe, einen substituierten, 1 bis 6 Kohlenstoffatome aufweisenden, geradkettigen, verzweigten oder cyclischen Akyl-, Alkenyl- oder Alkinylrest oder einen substituierten Acylrest, einen geradkettigen oder verzweigten Alkoxyrest, einen Amidyl-, Carboxyl-, Alkoxyalkyl-, Alkylamino-, Alkylsulfonyl- oder Sulfonsäurerest bedeuten, oder Salzen oder Derivaten hiervon, und aus Hydrazinen der Formel 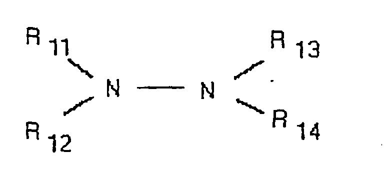 worin R₁₁, R₁₂, R₁₃ und R₁₄ unabhängig voneinander Wasserstoff, eine Hydroxylgruppe, einen substituierten, 1 bis 6 Kohlenstoffatome aufweisenden, geradkettigen, verzweigten oder cyclischen Alkyl-, Alkenyl- oder Alkinylrest, einen substituierten Acylrest, einen geradkettigen oder verzweigten Alkoxyrest, einen Amidyl-, Carboxyl-, Alkoxyalkyl-, Alkylamino-, Alkylsulfonyl- oder Sulfonsäurerest bedeuten, oder Salzen hiervon, (b) etwa 10 bis 80 Gew% eines oder mehrerer organischer Lösungsmittel, die mit dem nucleophilen Amin mischbar sind, (c) Wasser und gegebenenfalls (d) etwa 2,5 bis 30 Gew% einer oder mehrerer Verbindungen, die ausgewählt sind aus der Gruppe, bestehend aus
einem Dihydroxybenzol der Formel 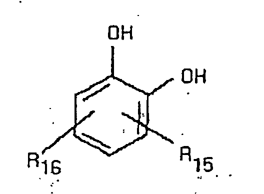 oder Isomeren hiervon, worin R₁₅ und R₁₆ entweder H, t-Butyl, OH oder COOH bedeuten,
einer Verbindung der Formel 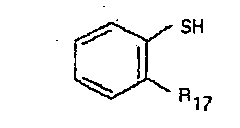 worin R₁₇ OH oder COOH bedeutet,
einer Ethylendiamintetracarbonsäure der Formel 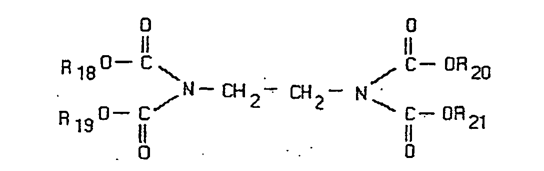 worin R₁₈, R₁₉, R₂₀ und R₂₁ entweder H oder NH₄ bedeuten, und einem Ammoniumsalz hiervon sowie
einem Alkylammoniumhydroxid der Formel
R₁R₂R₃R₄NOH
worin R₁, R₂, R₃ und R₄ unabhängig voneinander entweder H oder einen kurzkettigen Alkylrest mit 1 bis 5 Kohlenstoffatomen bedeuten, mit der Maßgabe, daß, wenn die Komponente (d) nicht vorliegt, mindestens einer der Reste R₅, R₆ und R₇ nicht Wasserstoff darstellt, und mindestens einer der Reste R₁₁, R₁₂, R₁₃ und R₁₄ nicht Wasserstoff bedeutet, zum Entfernen eines Abdeckmaterials oder Ätzrückstands von einem Substrat, die nach dem Ätzen zurückbleiben, durch Kontaktieren des Substrats mit einer Zusammensetzung, wobei der Kontakt bei einer Temperatur und während einer Zeit stattfindet, die ausreichen, um den Ätzrückstand oder die restlichen Abdeckmassennebenprodukte von dem Substrat zu entfernen.

17. Verwendung einer Zusammensetzung nach Anspruch 16, worin die Komponente (d) vorliegt und das nucleophile Amin gemäß (a) Hydroxylamin, ein Hydroxylaminderivat, Hydrazin oder ein Hydrazinderivat ist.

18. Verwendung der Zusammensetzung nach Anspruch 17, worin das nucleophile Amin gemäß (a) Hydroxylamin ist und die Komponente (d) mindestens eine Verbindung der Formel 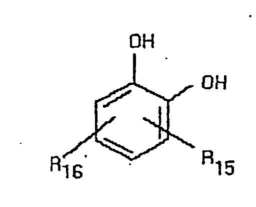 worin R₁₅ und R₁₆ entweder H, t-Butyl, OH oder COOH bedeuten, und Wasser enthält, bei einer Temperatur und während einer Zeit, die ausreichen, um den Ätzrückstand oder die Abdeckmasse von dem Substrat zu entfernen.

19. Verwendung einer Zusammensetzung nach Anspruch 16, worin das nucleophile Amin gemäß (a) Hydroxylamin ist und die mindestens eine Verbindung gemäß (d) in einer Menge von etwa 5 bis 30 Gew% vorliegt.

20. Verwendung einer Zusammensetzung nach Anspruch 16, worin die Komponente (d) vorliegt und das nucleophile Amin gemäß (a) N,N-Diethylhydroxylamin ist.

21. Verwendung einer Zusammensetzung nach einem der Ansprüche 16 bis 20, worin die Komponente (d) vorliegt und das organische Lösungsmittel gemäß (b) ein Alkanolamin ist.

22. Verwendung einer Zusammensetzung nach Anspruch 21, worin das Alkanolamin mindestens einen Alkanolrest aufweist, der 1 bis 5 Kohlenstoffatome enthält.

23. Verwendung einer Zusammensetzung nach Anspruch 21, worin das Alkanolamin ein Monoamin oder ein Diamin ist.

24. Verwendung einer Zusammensetzung nach Anspruch 21, worin das Alkanolamin die Formel R₁R₂N-CH₂CH₂-0-CH₂CH₂OH aufweist, worin R₁ und R₂ H, CH₃, CH₃CH₂ oder CH₂CH₂OH bedeuten.

25. Verwendung einer Zusammensetzung nach Anspruch 21, worin das Alkanolamin ein Aminoalkoxyalkanol ist.

26. Verwendung einer Zusammensetzung nach Anspruch 21, worin das Alkanolamin Monoethanolamin, Diglycolamin oder Monoisopropanolamin ist.

27. Verwendung einer Zusammensetzung nach Anspruch 16, worin das nucleophile Amin gemäß (a) Hydroxylamin ist und in einer Menge von etwa 17,5 Gew% vorliegt, das organische Lösungsmittel gemäß (b) Diglycolamin ist und in einer Menge von mindestens etwa 60 Gew% vorliegt, die Verbindung gemäß (d) Brenzcatechin oder Catechin ist und in einer Menge von mindestens etwa 2 Gew% vorliegt und das Wasser in einer Menge von etwa 17,5 Gew% vorliegt.

28. Verwendung einer Zusammensetzung nach Anspruch 18 oder 27, worin das Hydroxylamin und das Wasser in einem Verhältnis von etwa 50 zu 50 vorliegen.

29. Verwendung einer Zusammensetzung nach Anspruch 14 zum Entfernen eines Abdeckmaterials und eines Ätzrückstands von Substraten.

30. Verwendung einer Zusammensetzung nach Anspruch 20, worin das N,N-Diethylhydroxylamin in einer Menge von etwa 17,5 Gew% vorliegt, das organische Lösungsmittel gemäß (b) Diglykolamin ist und in einer Menge von mindestens etwa 60 Gew% vorliegt und das Wasser in einer Menge von etwa 17,5 Gew% vorliegt.

31. Verwendung einer Zusammensetzung nach einem der Ansprüche 16 bis 30, worin das Substrat eine Halbleiterscheibe ist.

32. Verwendung einer Zusammensetzung nach einem der Ansprüche 16 bis 31, worin die Temperatur im Bereich von etwa Raumtemperatur bis 100 °C und die Zeit im Bereich von 2 bis 60 Minuten liegen.

## Revendications

1. Une composition d'élimination de résidu de résine et de gravure, pour éliminer un résidu restant suite à une gravure, comprenant (a) de 5 à 50 % environ en poids d'un ou plusieurs composés aminés nucléophiles ayant des potentiels d'oxydation et de réduction, choisis dans le groupe constitué par un composé ayant pour formule : 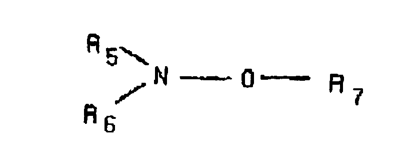 dans laquelle R₅, R₆ et R₇ sont indépendamment un hydrogène, un groupement hydroxyle, un groupement en C₁ à C₆ substitué linéaire, ramifié ou cycloalkyle, alcényle ou alcynyle substitué, un groupement acyle substitué, un groupement alcoxy linéaire ou ramifié, un groupement amidyle, un groupement carboxyle, un groupement alcoxyalkyle, un groupement alkylamino, un groupement alkylsulfonyle ou un groupement acide sulfonique ou des sels et dérivés de ceux-ci ; et des hydrazines représentées par une formule : 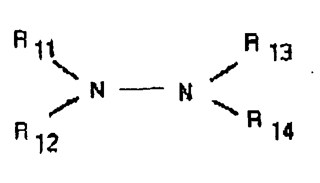 dans laquelle R₁₁, R₁₂, R₁₃ et R₁₄ sont indépendamment un hydrogène, un groupement hydroxyle, un groupement en C₁ à C₆ substitué linéaire, ramifié ou cycloalkyle, alcényle ou alcynyle substitué en C₁ à C₆, un groupement acyle substitué, un groupement alcoxy linéaire ou ramifié, un groupement amidyle, un groupement carboxyle, un groupement alcoxyalkyle, un groupement alkylamino, un groupement alkylsulfonyle, un groupement acide sulfonique ou des sels de ceux-ci ; (b) de 10 à 80 % environ en poids d'un ou plusieurs solvants organiques qui sont miscibles avec le composé aminé nucléophile ; (c) de l'eau ; et, éventuellement, (d) environ 2,5 à 30 % en poids d'un ou plusieurs composés choisis dans le groupe constitué par
un composé dihydroxybenzène ayant pour formule: 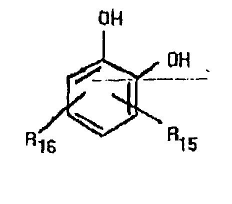 ou un isomère de ce composé dans lequel R₁₅ et R₁₆ peuvent être soit H, soit t-butyle, soit OH, soit COOH,
un composé ayant pour formule : 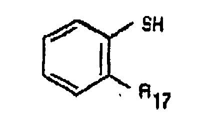 dans laquelle R₁₇ est OH ou COOH,
un acide éthylène diamine tétracarboxylique ayant pour formule : 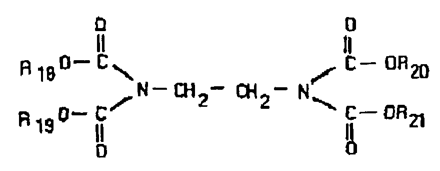 dans laquelle R₁₈, R₁₉, R₂₀ et R₂₁ peuvent être soit H, soit NH₄ et un sel d'ammonium de ce composé,
et un hydroxyde d'alkylammonium de formule :
R₁R₂R₃R₄NOH,
dans laquelle R₁, R₂, R₃ et R₄ peuvent être indépendamment soit H, soit un groupement alkyle à chaîne courte ayant de 1 à 5 atomes de carbone, à condition que, quand le composé (d) n'est pas présent, au moins l'un des R₅, R₆ et R₇ ne soit pas l'hydrogène et qu'au moins l'un des R₁₁, R₁₂, R₁₃ et R₁₄ ne soit pas l'hydrogène ; et dans laquelle le composé aminé nucléophile et le solvant organique sont présents dans des quantités suffisantes pour éliminer le résidu de résine et de gravure d'un substrat

2. La composition selon la revendication 1, dans laquelle le composé (d) est présent, et le composé aminé nucléophile de (a) est l'hydroxylamine, un dérivé de l'hydroxylamine, l'hydrazine ou un dérivé de l'hydrazine.

3. La composition selon la revendication 2, dans laquelle le composé aminé nucléophile de (a) est l'hydroxylamine, et le composé (d) comprend au moins un composé de formule : 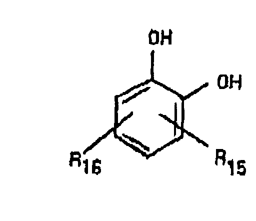 dans laquelle R₁₅ et R₁₆ peuvent être soit H, soit t-butyle, soit OH, soit COOH et de l'eau, dans laquelle l'hydroxylamine, le ou les solvants organiques de (b) et le ou les composés de (d) sont présents dans des quantités suffisantes pour éliminer le résidu de gravure ou une résine d'un substrat.

4. La composition selon la revendication 1, dans laquelle le composé aminé nucléophile de (a) est l'hydroxylamine, et le ou les composés de (d) sont présents en une quantité d'environ 5 à 30 % en poids.

5. La composition selon la revendication 1, dans laquelle le composé (d) est présent, et le composé aminé nucléophile de (a) est la N,N-diéthyl hydroxylamine.

6. La composition selon l'une quelconque des revendications précédentes dans laquelle le composé (d) est présent et le solvant organique de (b) est une alcanolamine.

7. La composition selon la revendication 6, dans laquelle l'alcanolamine comporte au moins un groupement alcanol contenant de 1 à 5 atomes de carbone.

8. La composition selon la revendication 6, dans laquelle l'alcanolamine est une monoamine ou une diamine.

9. La composition selon la revendication 6, dans laquelle l'alcanolamine a la formule R₁R₂-N-CH₂CH₂-O-CH₂CH₂-OH, dans laquelle R₁ et R₂ peuvent être H, CH₃, CH₃CH₂ ou CH₂CH₂OH.

10. La composition selon la revendication 6, dans laquelle l'alcanolamine est un amino alcoxy alcanol.

11. La composition selon la revendication 6, dans laquelle l'alcanolamine est la monoéthanolamine, la diglycolamine ou la monoisopropanolamine.

12. La composition selon la revendication 1, dans laquelle le composé aminé nucléophile de (a) est l'hydroxylamine et est présent en une quantité d'environ 17,5 pour cent en poids, le solvant organique de (b) est la diglycolamine, et la diglycolamine est présente en une quantité d'au moins environ 60 pour cent en poids, le composé de (d) est le catéchol, et le catéchol est présent en une quantité d'au moins environ 2 pour cent en poids et l'eau est présente en une quantité d'environ 17,5 pour cent en poids.

13. La composition selon la revendication 3 ou 12, dans laquelle l'hydroxylamine et l'eau sont présentes dans un rapport d'environ 50:50.

14. Une composition de nettoyage pour éliminer le résidu de résine et de gravure de substrats, contenant de l'hydroxylamine, au moins une alcanolamine, de l'eau et un agent de chélation.

15. La composition selon la revendication 5, dans laquelle la N,N-diéthyl hydroxylamine est présente en une quantité d'environ 17,5 pour cent en poids, le solvant organique de (b) est la diglycolamine et est présent en une quantité d'au moins environ 60 pour cent en poids et l'eau est présente en une quantité d'environ 17,5 pour cent en poids.

16. L'utilisation, pour éliminer un résidu de résine ou de gravure restant suite à une gravure d'un substrat par mise en contact du substrat avec une composition, d'une composition comprenant (a) environ 5 à 50 % en poids d'un ou plusieurs composés aminés nucléophiles ayant des potentiels d'oxydation et de réduction, choisis dans le groupe constitué par un composé ayant pour formule : 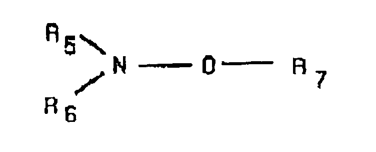 dans laquelle R₅, R₆ et R₇ sont indépendamment un hydrogène, un groupement hydroxyle, un groupement en C₁ à C₆ substitué linéaire, ramifié ou cycloalkyle, alcényle ou alcynyle substitué en C₁ à C₆, un groupement acyle substitué, un groupement alcoxy linéaire ou ramifié, un groupement amidyle, un groupement carboxyle, un groupement alcoxyalkyle, un groupement alkylamino, un groupement alkylsulfonyle ou un groupement acide sulfonique ou des sels et dérivés de ceux-ci ; et des hydrazines représentées par une formule : 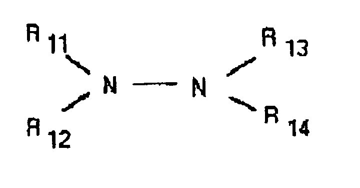 dans laquelle R₁₁, R₁₂, R₁₃ et R₁₄ sont indépendamment un hydrogène, un groupement hydroxyle, un groupement en C₁ à C₆ substitué linéaire, ramifié, ou cycloalkyle, alcényle ou alcynyle substitué en C₁ à C₆, un groupement acyle substitué, un groupement alcoxy linéaire ou ramifié, un groupement amidyle, un groupement carboxyle, un groupement alcoxyalkyle, un groupement alkylamino, un groupement alkylsulfonyle, un groupement acide sulfonique ou des sels de ceux-ci ; (b) environ 10 à 80 % en poids d'un ou plusieurs solvants organiques qui sont miscibles avec le composé aminé nucléophile ; (c) de l'eau ; et, éventuellement, (d) environ 2,5 à 30 % en poids d'un ou plusieurs composés choisis dans le groupe constitué par
un composé dihydroxybenzène ayant pour formule : 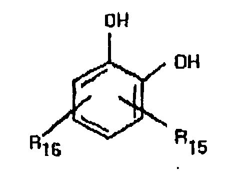 ou un isomère de ce composé dans lequel R₁₅ et R₁₆ peuvent être soit H, soit t-butyle, soit OH, soit COOH,
un composé ayant pour formule : 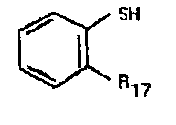 dans laquelle R₁₇ est OH ou COOH,
un acide éthylène diamine tétracarboxylique ayant pour formule : 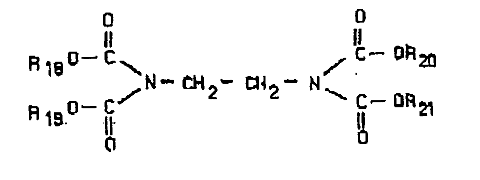 dans laquelle R₁₈, R₁₉, R₂₀ et R₂₁ peuvent être soit H, soit NH₄ et un sel d'ammonium de ce composé,
et un hydroxyde d'alkylammonium de formule :
R₁R₂R₃R₄NOH,
dans laquelle R₁, R₂, R₃ et R₄ peuvent être indépendamment soit H, soit un groupement alkyle à chaîne courte ayant de 1 à 5 atomes de carbone, à condition que, quand le composé (d) n'est pas présent, au moins l'un des R₅, R₆ et R₇ ne soit pas l'hydrogène et qu'au moins l'un des R₁₁, R₁₂, R₁₃ et R₁₄ ne soit pas l'hydrogène ; dans laquelle le contact est réalisé à une température et pendant une durée suffisantes pour éliminer du substrat le résidu de gravure ou les produits secondaires résiduels de la résine photosensible.

17. L'utilisation d'une composition selon la revendication 16, dans laquelle le composé (d) est présent et le composé aminé nucléophile de (a) est l'hydroxylamine, un dérivé de l'hydroxylamine, l'hydrazine ou un dérivé de l'hydrazine.

18. L'utilisation de la composition selon la revendication 17, dans laquelle le composé aminé nucléophile de (a) est l'hydroxylamine, et le composé (d) comprend au moins un composé de formule: 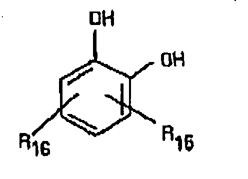 dans laquelle R₁₅ et R₁₆ peuvent être soit H, soit t-butyle, soit OH, soit COOH et de l'eau, à une température et pendant une durée suffisantes pour éliminer le résidu de gravure ou la résine du substrat.

19. L'utilisation de la composition selon la revendication 16, dans laquelle le composé aminé nucléophile de (a) est l'hydroxylamine, et le ou les composés de (d) sont présents en une quantité d'environ 5 à 30 % en poids.

20. L'utilisation d'une composition selon la revendication 16, dans laquelle le composé (d) est présent, et le composé aminé nucléophile de (a) est la N,N-diéthyl hydroxylamine.

21. L'utilisation d'une composition selon l'une des revendications 16 à 20, dans laquelle le composé (d) est présent, et le solvant organique de (b) est une alcanolamine.

22. L'utilisation d'une composition selon la revendication 21, dans laquelle l'alcanolamine comporte au moins un groupement alcanol contenant de 1 à 5 atomes de carbone.

23. L'utilisation d'une composition selon la revendication 21, dans laquelle l'alcanolamine est une monoamine ou une diamine.

24. L'utilisation d'une composition selon la revendication 21, dans laquelle l'alcanolamine a la formule R₁R₂-N-CH₂CH₂-O-CH₂CH₂OH, dans laquelle R₁ et R₂ peuvent être H, CH₃, CH₃CH₂ ou CH₂CH₂OH.

25. L'utilisation d'une composition selon la revendication 21, dans laquelle l'alcanolamine est un amino alcoxy alcanol.

26. L'utilisation d'une composition selon la revendication 21, dans laquelle l'alcanolamine est la monoéthanolamine, la diglycolamine ou la monoisopropanolamine.

27. L'utilisation d'une composition selon la revendication 16, dans laquelle le composé aminé nucléophile de (a) est l'hydroxylamine et est présent en une quantité d'environ 17,5 pour cent en poids, le solvant organique de (b) est la diglycolamine, et la diglycolamine est présente en une quantité d'au moins environ 60 pour cent en poids, le composé de (d) est le catéchol, et le catéchol est présent en une quantité d'au moins environ 2 pour cent en poids, et l'eau est présente en une quantité d'environ 17,5 pour cent en poids.

28. L'utilisation d'une composition selon la revendication 18 ou 27, dans laquelle l'hydroxylamine et l'eau sont présentes dans un rapport d'environ 50:50.

29. L'utilisation d'une composition selon la revendication 14 pour éliminer des substrats la résine et le résidu de gravure.

30. L'utilisation d'une composition selon la revendication 20, dans laquelle la N,N-diéthyl hydroxylamine est présente en une quantité d'environ 17,5 pour cent en poids, le solvant organique de (b) est la diglycolamine et est présent en une quantité d'au moins environ 60 pour cent en poids et l'eau est présente en une quantité d'environ 17,5 pour cent en poids.

31. L'utilisation d'une composition selon l'une quelconque des revendications 16 à 30, dans laquelle le substrat est une tranche de semiconducteur.

32. L'utilisation d'une composition selon l'une quelconque des revendications 16 à 31, dans laquelle la température se situe dans la plage allant d'environ la température ambiante à 100 °C et la durée se situe dans la plage allant de 2 à 60 minutes.
